# FASCICULE DE BREVET EUROPEEN

(11) **EP 2 079 096 B1**
(45) Date de publication et mention de la délivrance du brevet: **18.04.2012**
(21) Numéro de dépôt: 08290027.5
(22) Date de dépôt: 11.01.2008
(51) Int. Cl.: H01J 27/08, H05H 1/48

(54) **Source d'ions à décharge électrique par filament**
Ionenquelle mit elektrischer Entladung über Glühfaden
Ion source with filament electric discharge

(43) Date de publication de la demande: 15.07.2009
(73) Titulaire: Excico Group N.V., 2018 Antwerpen (BE)
(72) Inventeur: Makarov, Maxime, 92230 Gennevilliers (FR); Mestres, Marc, 92230 Gennevilliers (FR)
(74) Mandataire: de Kernier, Gabriel

(56) Documents cités:
- FR-A1- 2 596 580
- JP-A- 6 005 219
- JP-A- 2000 012 282
- US-A- 4 412 153
- US-A- 4 608 513
- US-A1- 2006 097 185

## Description

L'invention concerne le domaine des sources pulsées d'ions et des dispositifs mettant en oeuvre de telles sources, par exemple des générateurs de plasma.

Le document US 3,156,842 concerne un ionisateur de gaz comprenant une électrode creuse présentant une forme de révolution, une électrode en forme de tige positionnée le long de l'axe de l'électrode creuse et de section transversale très inférieure à celle de l'électrode creuse, des moyens pour fournir un gaz à très faible pression dans l'espace délimité par l'électrode creuse, et des moyens pour éloigner les électrons des extrémités de l'électrode creuse.

On peut également se reporter aux documents US 3,970,892, US 4,025,818, US 4,642,522, US 4,694,222, US 4,910,435 et FR 2 591 035. Le document JP 2000-012282 décrit un générateur de plasma triphasé à filaments disposés à 120° alimentés par leurs deux extrémités. Le document US 4 608 513 décrit une source ionique à deux filaments dont les deux extrémités sont isolées par rapport à l'enceinte tout en la traversant, chacune étant alimentée électriquement. Dans le cas où une électrode se présente sous la forme d'un filament fin, il s'est avéré difficile de réaliser une source ionique de grande taille, de fort courant et homogène. En effet, la décharge électrique se forme de façon hétérogène le long du filament et se montre instable. Le filament peut devenir localement incandescent. La surface interne des parois de la chambre peut voir ses propriétés émissives évoluer. On peut envisager d'utiliser plusieurs filaments longs montés en parallèle le long de l'axe de la chambre de décharge. Toutefois, la décharge se forme alors de façon hétérogène le long des filaments et l'on rencontre des difficultés mécaniques liées à la dilatation et la vibration du filament. Si l'on utilise plusieurs filaments courts montés perpendiculairement à l'axe de la chambre de décharge, le dispositif mécanique devient compliqué, notamment en raison de la présence de nombreuses traversées de parois hermétiques au gaz et isolées électriquement. On peut envisager d'alimenter chaque filament séparément. Des alimentations électriques multiples sont alors requises, ce qui complique considérablement la partie électrique de l'installation.

En outre, il reste difficile de former une décharge remplissant la chambre à faible pression d'une manière homogène et stable.

L'invention a notamment pour but de remédier aux inconvénients de l'art antérieur évoqués ci-dessus.

L'invention a notamment pour but de fournir une source ionique de grande taille, homogène et stable.

Une source d'ions à décharge électrique par filaments comprend une chambre d'ionisation munie de parois intérieures et configurée pour contenir un gaz à ioniser, des filaments disposés dans la chambre d'ionisation, et une alimentation électrique des filaments. Les filaments sont disposés sensiblement parallèlement les uns aux autres et reliés à l'alimentation à travers les parois intérieures. Au moins un premier filament est relié à l'alimentation à travers une première paroi intérieure et au moins un deuxième filament est relié à l'alimentation à travers une deuxième paroi intérieure opposée à la première paroi intérieure.

La Demanderesse s'est en effet rendu compte que l'alimentation en courant des filaments d'une manière croisée avec des filaments alimentés par les côtés opposés de la chambre d'ionisation permet d'atténuer fortement l'effet négatif que le champ magnétique produit sur l'ionisation du gaz. Le courant atteignant quelques centaines d'ampères génère un champ magnétique assez élevé, par exemple de l'ordre de plusieurs millièmes de teslas à la distance d'un centimètre du filament pour que le rayon giratoire d'un électron libre soit de l'ordre de 0,03 mm et donc largement inférieur au parcours libre moyen. Pour un tel électron, il devient alors peu probable d'ioniser le gaz. L'alimentation croisée permet de réduire le champ magnétique d'un facteur de l'ordre de 10 à 100.

Les filaments peuvent être montés en nombre pair. Le nombre de filaments peut être égal à 2, 4, 6, 8 ou encore 10. Dans le cas où le nombre de filaments est supérieur ou égal à 4, la disposition des filaments peut être prévue de telle sorte qu'un premier filament est voisin d'une pluralité de deuxièmes filaments et qu'un deuxième filament est voisin d'une pluralité de premiers filaments. Le terme "voisin" peut être compris comme signifiant voisin le plus proche.

Dans le cas d'un montage à quatre filaments, lesdits filaments peuvent présenter une disposition carrée en coupe transversale avec les premiers filaments selon une diagonale et les deuxièmes filaments selon l'autre diagonale. Les quatre filaments peuvent également être disposés en une nappe plane, les premiers filaments et les deuxièmes filaments étant alternés. Dans le cas d'un montage à six filaments, lesdits filaments peuvent présenter une disposition hexagonale avec alternance de premiers et de deuxièmes filaments, une disposition rectangulaire, ou encore une disposition en nappe plane. Dans le cas d'un montage à huit filaments, lesdits filaments peuvent être disposés en deux groupes de quatre séparés par un espace plus important que l'espace séparant deux filaments voisins, en rectangle à espacement constant, en octogone, en nappe plane, etc.

L'alimentation peut être configurée pour fournir un courant inférieur à un ampère par centimètre de longueur de filament. On favorise l'homogénéité de la décharge.

Dans un mode de réalisation, les filaments sont parallèles à un axe de la chambre d'ionisation. Les filaments peuvent être parallèles à l'axe longitudinal de la chambre d'ionisation. Le nombre de traversées électriques des parois étanches au gaz est alors faible.

Dans un mode de réalisation, les filaments sont parallèles à un axe d'une chambre d'accélération.

La distance minimale entre deux filaments peut-être supérieure à 40, de préférence 50, fois le diamètre d'un filament. On obtient ainsi une certaine indépendance de la décharge de chaque filament en fonctionnement. La vibration, le défaut de positionnement ou le défaut de rectitude d'un filament produit une perturbation négligeable de la décharge autour d'un filament voisin. Les filaments peuvent être de diamètre égal.

Le périmètre interne minimal de la chambre d'ionisation peut être supérieur au produit d'une constante, du nombre de filaments dans la chambre d'ionisation, du diamètre des filaments et d'un paramètre représentatif de la masse atomique du gaz présent dans la chambre d'ionisation. Le périmètre interne minimal de la chambre d'ionisation peut être supérieur à 100 fois le produit du nombre de filaments dans la chambre d'ionisation, du diamètre d'un filament et de la racine carrée de la masse atomique du gaz présent dans la chambre d'ionisation. On améliore ainsi l'homogénéité de la décharge.

Dans un mode de réalisation, les filaments comprennent du tungstène, par exemple un alliage de tungstène. Les filaments peuvent comprendre un métal à point de fusion supérieur à 2000 K. Les filaments sont de préférence en métal dur conditionné pour des hautes températures.

Dans un mode de réalisation, les filaments présentent un diamètre compris entre 0,1 et 0,5 mm, de préférence entre 0,15 et 0,3 mm.

Dans un mode de réalisation, la pression de gaz à ioniser dans la chambre d'ionisation est comprise entre 0,5 et 100 pascals, de préférence entre 1 et 20 pascals.

Dans un mode de réalisation, le gaz à ioniser comprend de l'hélium.

Dans un mode de réalisation, le gaz à ioniser comprend de l'hélium et de 5 % à 25 % massiques de néon, de préférence entre 5 et 15 %. L'homogénéité spatiale de la décharge est améliorée.

Dans un mode de réalisation, le nombre de filaments est déterminé par le courant total fourni par l'alimentation électrique.

Dans un mode de réalisation, le périmètre de la section transversale de la chambre d'ionisation est déterminé par le diamètre des filaments, le nombre des filaments et la nature du gaz présent dans la chambre d'ionisation.

L'alimentation électrique des filaments peut être unique.

La présente invention sera mieux comprise à la lecture de la description détaillée de quelques modes de réalisation pris à titre d'exemples non limitatifs et illustrés par les dessins annexés, sur lesquels :
- la figure 1 est une vue schématique en coupe longitudinale d'une source ionique ; et
- les figures 2 à 6 sont des vues schématiques en coupe transversale de sources ioniques.

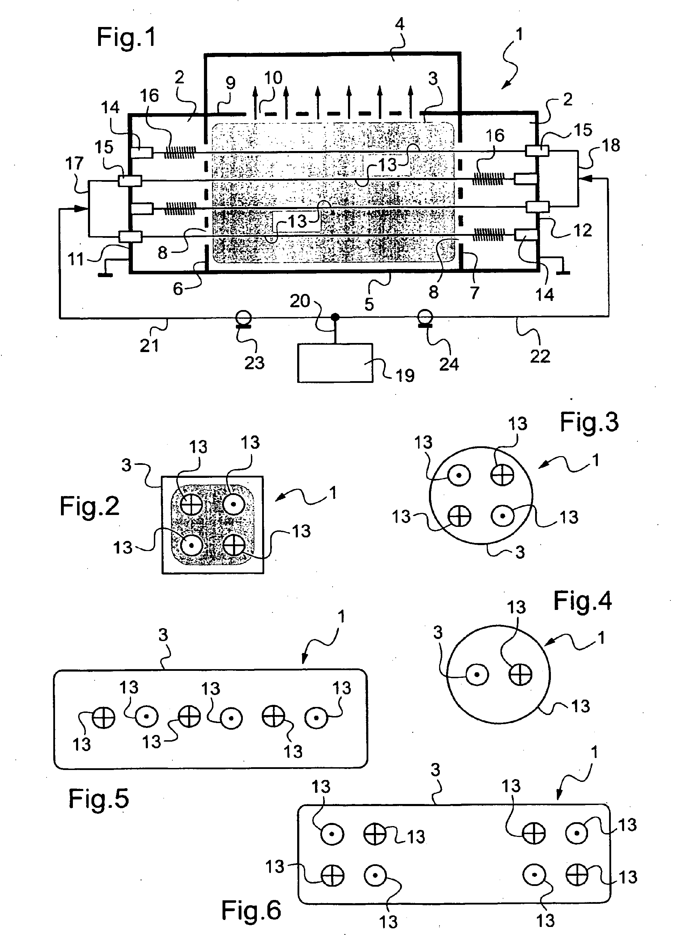

Comme on peut le voir sur la figure 1, la source d'ions 1 comprend deux chambres de connexion 2, une chambre d'ionisation 3 disposée entre les chambres de connexion 2 et un système d'extraction des ions 4. Le système d'extraction des ions 4 dépend de l'application dans laquelle la source d'ions 1 est utilisée. Le système d'extraction des ions 4 peut comprendre une chambre d'accélération ou chambre de décharge permettant de conférer une vitesse d'éjection élevée à des électrons, par exemple pour un canon à électrons. La chambre d'ionisation 3 présente en général une forme allongée avec deux chambres d'ionisation disposées aux extrémités opposées. Le système d'extraction d'ions 4 peut être monté latéralement par rapport à la chambre d'ionisation 3.

Les chambres de connexion 2, d'ionisation 3 et le système d'extraction d'ions 4 forment une enceinte étanche aux gaz. Ladite enceinte peut être remplie de gaz rare, notamment d'hélium, de néon et/ou d'argon. La pression de gaz régnant dans l'enceinte peut être comprise entre 0,5 pascal et 100 pascals, une pression comprise entre 1 pascal et 20 pascals est préférée.

La chambre d'ionisation 3 comprend une paroi inférieure 5 étanche, et deux parois d'extrémité 6 et 7 communes avec les chambres de connexion 2. Des orifices 8 de passage sont ménagés dans les parois d'extrémité 6 et 7. La chambre d'ionisation 3 comprend une paroi supérieure 9 commune avec le système d'extraction d'ions 4. Des fentes 10 d'extraction d'ions sont ménagées dans la paroi 9 mettant ainsi en communication la chambre d'ionisation 3 et le système d'extraction d'ions 4. Les parois avant et arrière de la chambre d'ionisation 3, non visibles sur la figure 1, sont étanches au gaz.

Les chambres de connexion 2 comprennent des parois inférieure et supérieure étanches au gaz et situées dans le prolongement des parois inférieure 5 et supérieure 9 de la chambre d'ionisation 4. Les chambres de connexion 2 sont obturées à leurs extrémités par des parois d'extrémité 11 et 12. Les parois formant l'enceinte étanche au gaz peuvent être réalisées en acier inoxydable ou en laiton et plus généralement dans tout matériau métallique présentant la résistance mécanique requise en raison notamment de la faible pression intérieure et les propriétés physiques et chimiques liées à l'ionisation à l'intérieur de la chambre d'ionisation 3. Le cas échéant, un revêtement en un autre métal ou alliage métallique peut être formé sur les parois intérieures de ladite enceinte, par exemple en aluminium ou nickel.

La chambre d'ionisation 3 comprend une pluralité de filaments 13 parallèles les uns aux autres. Les filaments 13 sont préférablement en nombre pair. Les filaments 13 sont allongés selon la dimension principale de la chambre d'ionisation 3. En d'autres termes, les filaments 13 sont parallèles à l'axe principal de la chambre d'ionisation 3. Les filaments 13 sont montés à distance des parois inférieure 5 et supérieure 9. La distance entre deux filaments 13 voisins est inférieure à la distance entre un filament 13 et une paroi inférieure 5 ou supérieure 9. Les filaments 13 passent dans les orifices 8 ménagés dans les parois d'extrémité 6 et 7 de la chambre d'ionisation 3. Les orifices 8 forment ainsi un passage pour les filaments 13. Dans un orifice 8, un filament 13 reste à une distance de la matière formant ladite paroi d'extrémité 6, 7, inférieure à 10 fois le diamètre du filament.

La chambre d'ionisation 3 peut présenter une forme cylindrique ou torique. Dans ce cas, les filaments 3 peuvent être supportés en plusieurs points régulièrement répartis par des isolateurs. Les filaments peuvent être polygonaux.

Les chambres de connexion 2 comprennent des moyens de support des filaments 13. Plus particulièrement, un filament 13 est supporté à une extrémité par un isolateur de fixation 14, par exemple à base de céramique, fixé sur une face interne d'une paroi d'extrémité 11, 12 d'une chambre de connexion 2. A l'extrémité opposée du filament 13, ledit filament 13 est supporté par un isolateur étanche 15 traversant la paroi d'extrémité 12, 11 par un orifice prévu à cet effet. L'isolateur 15 assure à la fois une fonction de traversée électrique, de support mécanique du filament 13 et d'étanchéité au gaz. La traversée électrique permet au filament 13 d'être reliée électriquement à l'extérieur des chambres d'ionisation 3 et de connexion 2. En outre, un ressort 16 peut être interposé entre le filament 13 et un isolateur, de préférence un isolateur de fixation 14. Le ressort 16 est disposé dans une chambre de connexion 2. Le ressort 16 assure la tension mécanique du filament 13.

Deux filaments 13 voisins sont supportés par des isolateurs étanches 15 disposés l'un sur la paroi d'extrémité 11 et l'autre sur la paroi d'extrémité 12. En d'autres termes, les filaments 13 sont alimentés de façon croisée. Dans le mode de réalisation illustré sur la figure 1 avec quatre filaments 13 disposés en nappe plane, les filaments de rangs un et trois numérotés en partant du bas sont reliés à des isolateurs 15 traversant la paroi d'extrémité 11. Les filaments 13 de rangs deux et quatre sont supportés par des isolateurs étanches 15 montés dans la paroi d'extrémité 12. Les filaments 13 de rangs un et trois sont reliés ensemble par un câble électrique 17. Les filaments 13 de rangs deux et quatre sont reliés ensemble par un câble électrique 18. L'alimentation électrique 19 peut comprendre une sortie de puissance 20, par exemple une sortie unique. La sortie 20 de l'alimentation 19 peut être reliée par un câble 21 au câble 17 et par un câble 22 au câble 18 assurant ainsi l'alimentation électrique des filaments 13. L'alimentation électrique peut être configurée pour fournir un courant d'intensité inférieure ou égale à un ampère par centimètre de longueur de filament dans chaque filament 13. Des capteurs de courant, par exemple sous forme de boucles de courant 23 et 24, peuvent être montés sur les câbles électriques 21 et 22 respectivement pour mesurer le courant passant dans lesdits câbles électriques 21 et 22 et consommés par les filaments 13. La sortie des capteurs de courant 23 et 24 peut être reliée à une unité de commande de l'alimentation électrique 19 en vue d'une régulation.

Le diamètre des filaments peut être compris entre 0,1 et 0,5 mm. La demanderesse s'est rendu compte qu'un diamètre compris entre 0,15 et 0,3 mm était particulièrement intéressant, par exemple de 0,2 mm. La distance minimale entre deux filaments est en général supérieur 40 fois le diamètre d'un filament, de préférence 50 fois. Ainsi, pour un diamètre de filament de 0,2 mm, la distance minimale entre deux filaments est de 10 mm. Les filaments 13 sont réalisés en métal dur ou en alliage, adapté à résister à des températures élevées, notamment comprises entre 500 et 2000 K. On peut choisir un alliage métallique à point de fusion supérieur à 1900 K, voire 2000 K. Les filaments peuvent comprendre un métal réfractaire, par exemple un alliage de tungstène..

Le périmètre interne de la chambre d'ionisation 3 est supérieur ou égal au produit d'une constante, du nombre de filaments 13 dans la chambre d'ionisation 3, du diamètre des filaments 13 et d'un paramètre relatif à la masse atomique du gaz présent dans la chambre d'ionisation 3. A titre d'exemple, pour une source d'ions hélium avec quatre filaments de 0,02 cm de diamètre, le périmètre doit être supérieur à 100 X 0,02 cm X 4 X √2 = 11, 3 cm, ce qui peut être obtenu par une chambre de section carrée de 3,5 cm X 3,5 cm ou par une chambre tubulaire de 4 cm de diamètre. Bien entendu, en cas de mélange de gaz, le paramètre représentatif de la masse atomique pourra être la racine carrée de la moyenne pondérée des masses atomiques des gaz présents dans la chambre d'ionisation 3.

Dans le mode de réalisation illustré sur la figure 1, les filaments 13 sont présents au nombre de quatre disposés en une nappe plane. A titre de variante, les filaments 13 peuvent être disposés en une pluralité de nappes, chaque nappe comprenant quatre fils. Lesdites nappes sont parallèles les unes aux autres et peuvent être disposées l'une par rapport à l'autre à une distance égale à la distance séparant deux fils d'une nappe ou encore à une distance légèrement supérieure. Dans le mode de réalisation de la figure 2, les fils 13 sont présents au nombre de quatre disposés en carré vu en section transversale. Les connexions et les alimentations des fils sont alors croisées en ce sens que les fils alimentés par des isolateurs étanches 15 disposés dans la paroi 11 occupent une diagonale et que les autres fils 13 occupent l'autre diagonale du carré. La chambre d'ionisation 3 présente une section carrée.

Dans le mode de réalisation illustré sur la figure 3, la disposition des fils est semblable à celle de la figure 2. La chambre d'ionisation 3 présente une section circulaire. La source d'ions 1 présente alors une forme générale tubulaire ou torique.

Dans le mode de réalisation illustré sur la figure 4, la chambre d'ionisation 3 présente une forme semblable à celle du mode de réalisation de la figure 3. Les filaments 13 sont au nombre de deux, l'un relié à un isolateur étanche 15 supporté par la paroi 11 et l'autre relié à un isolateur étanche 15 supporté par la paroi d'extrémité 12. L'alimentation des filaments 13 provient d'extrémités opposées de la chambre d'ionisation 3.

Dans le mode de réalisation illustré sur la figure 5, la chambre d'ionisation 3 présente une section transversale rectangulaire. La chambre d'ionisation 3 peut présenter la forme générale d'un parallélépipède rectangle. La source d'ions 1 comprend six fils disposés en une nappe plane. Les filaments 13 alimentés par la paroi d'extrémité 11 sont alternés avec les filaments 13 alimentés par la paroi d'extrémité 12. Dans le cas d'une source d'ions hexafilaire et de forme générale tubulaire, une disposition des filaments en hexagone peut être prévue. Alternativement, six filaments peuvent être disposés en deux nappes de trois filaments, chaque nappe étant plane.

Dans le mode de réalisation illustré sur la figure 6, la chambre d'ionisation 3 présente une forme générale semblable à celle illustrée sur la figure 5. La source d'ions 1 comprend huit filaments 13 disposés en deux groupes de quatre éloignés l'un de l'autre, chaque groupe de filaments étant disposé en carré comme illustré sur la figure 3. Les filaments 13 peuvent également être disposés en une nappe de huit fils, en deux nappes de quatre fils ou encore en octogone.

En fonctionnement, l'alimentation électrique 19 est mise en marche et fournit une impulsion d'une durée comprise entre 1 et 10 microsecondes et dont le courant crête est compris par exemple entre 100 et 1000 A sous une tension comprise entre 1 et 10 kV. Une décharge se produit entre les filaments 13 formant une électrode et les parois internes de la chambre d'ionisation 3 formant l'autre électrode. La décharge dans le gaz produit des ions, par exemple He⁺. Les ions peuvent passer par les fentes 10 et être traités par le système d'extraction 4.

On dispose d'une source ionique de fonctionnement stable générant des flux d'ions homogènes et particulièrement bien adaptés à des installations de grande taille demandant un débit ionique élevé.

## Revendications

1. Source d'ions (1) à décharge électrique par filament, comprenant une chambre d'ionisation (3) munie de parois intérieures et configurée pour contenir un gaz à ioniser, des filaments (13) disposés dans la chambre d'ionisation (3), et une alimentation électrique (19) des filaments, les filaments (13) étant disposés sensiblement parallèlement les uns aux autres et reliés à l'alimentation (19) à travers les parois intérieures, au moins un premier filament étant relié à l'alimentation à travers une première paroi intérieure (11), **caractérisée par le fait que** le premier filament est supporté par un isolateur de fixation (14) fixé sur une face interne d'une deuxième paroi intérieure (12) opposée à la première paroi intérieure (11), et que au moins un deuxième filament est relié à l'alimentation à travers la deuxième paroi intérieure (12) et supporté par un isolateur de fixation (14) fixé sur une face interne de la première paroi intérieure (11).

2. Source selon la revendication 1 ou 2, dans laquelle un premier filament est voisin d'au moins un deuxième filament.

3. Source selon l'une quelconque des revendications précédentes, dans laquelle l'alimentation (19) est configurée pour fournir un courant inférieur à 1 ampère par centimètre de longueur de filament.

4. Source selon l'une quelconque des revendications précédentes, dans laquelle les filaments (13) sont parallèles à un axe de la chambre d'ionisation et/ou un axe d'une chambre d'accélération.

5. Source selon l'une quelconque des revendications précédentes, dans laquelle la distance minimale entre deux filaments est supérieure à 40, de préférence 50, fois le diamètre d'un filament.

6. Source selon l'une quelconque des revendications précédentes, dans laquelle le périmètre interne minimal de la chambre d'ionisation (3) est supérieur au produit d'une constante, du nombre de filaments (13) dans la chambre d'ionisation (3), du diamètre d'un filament (13), et d'un paramètre représentatif de la masse atomique du gaz présent dans la chambre d'ionisation (3).

7. Source selon la revendication 6, dans laquelle le périmètre interne minimal de la chambre d'ionisation (3) est supérieur à 100 fois le produit du nombre de filaments (13) dans la chambre d'ionisation (3), du diamètre d'un filament (13), et de la racine carrée de la masse atomique du gaz présent dans la chambre d'ionisation (3).

8. Source selon l'une quelconque des revendications précédentes, dans laquelle les filaments (13) comprennent un métal à point de fusion supérieur à 2000 K.

9. Source selon l'une quelconque des revendications précédentes, dans laquelle les filaments (13) présentent un diamètre compris entre 0,1 et 0,5 mm, de préférence entre 0,15 et 0,3 mm.

10. Source selon l'une quelconque des revendications précédentes, dans laquelle la pression de gaz à ioniser dans la chambre d'ionisation (3) est comprise entre 0,5 et 1 Pa, de préférence entre 1 et 20 Pa.

11. Source selon l'une quelconque des revendications précédentes, dans laquelle le gaz à ioniser comprend de l'hélium et de 5 à 25% de néon, de préférence entre 5 et 15%.

## Claims

1. Filament electrical discharge ion source (1), comprising an ionisation chamber (3) provided with internal walls and configured so as to contain a gas that is to be ionised, filaments (13) arranged in the ionisation chamber (3), and an electrical power supply (19) to the filaments, the filaments (13) being arranged substantially parallel to one another and connected to the power supply (19) through the internal walls, at least one first filament being connected to the power supply through a first internal wall (11), **characterised in that** the first filament is supported by a fixing insulator (14) fixed to an inner surface of a second internal wall (12) opposite the first internal wall (11), and that at least one second filament is connected to the power supply through the second internal wall (12) and supported by a fixing insulator (14) fixed to an inner surface of the first internal wall (11).

2. Source according to claim 1 or 2, wherein a first filament is adjacent to at least one second filament.

3. Source according to any one of the preceding claims, wherein the power supply (19) is configured so as to supply a current of less than 1 ampere per centimetre of the filament length.

4. Source according to any one of the preceding claims, wherein the filaments (13) are parallel to an axis of the ionisation chamber and/or an axis of an acceleration chamber.

5. Source according to any one of the preceding claims, wherein the minimum distance between two filaments is greater than 40, preferably 50, times the diameter of a filament.

6. Source according to any one of the preceding claims, wherein the minimum internal perimeter of the ionisation chamber (3) is greater than the product of a constant, the number of filaments (13) in the ionisation chamber (3), the diameter of a filament (13), and a parameter representing the atomic mass of the gas present in the ionisation chamber (3).

7. Source according to claim 6, wherein the minimum internal perimeter of the ionisation chamber (3) is more than 100 times the product of the number of filaments (13) in the ionisation chamber (3), the diameter of a filament (13) and the square root of the atomic mass of the gas present in the ionisation chamber (3).

8. Source according to any one of the preceding claims, wherein the filaments (13) comprise a metal with a melting point above 2000 K.

9. Source according to any one of the preceding claims, wherein the filaments (13) have a diameter of between 0.1 and 0.5 mm, preferably between 0.15 and 0.3 mm.

10. Source according to any one of the preceding claims, wherein the pressure of gas to be ionised in the ionisation chamber (3) is between 0.5 and 1 Pa, preferably between 1 and 20 Pa.

11. Source according to any one of the preceding claims, wherein the gas to be ionised comprises helium and 5 to 25% of neon, preferably between 5 and 15%.

## Patentansprüche

1. Ionenquelle (1) mit elektrischer Entladung über Glühfäden, mit einer lonisationskammer (3), die mit inneren Seitenwänden versehen ist und ausgestaltet ist, um ein zu ionisierendes Gas zu enthalten, Glühfäden (13), die in der lonisationskammer (3) angeordnet sind, und einer Stromzufuhr (19) zu den Glühfäden, wobei die Glühfäden (13) im Wesentlichen parallel zueinander angeordnet und mit der Stromzufuhr (19) durch die inneren Seitenwände angeordnet sind, wobei wenigstens ein erster Glühfaden mit der Zufuhr durch eine erste innere Seitenwand (11) verbunden ist, **dadurch gekennzeichnet, dass** der erste Glühfaden durch einen Befestigungsisolator (14) getragen wird, der auf einer Innenseite einer zweiten inneren Seitenwand (12), entgegengesetzt zur ersten inneren Seitenwand (11), befestigt ist, wobei wenigstens ein zweiter Glühfaden mit der Zuführung durch die zweite innere Seitenwand (12) verbunden ist, und gestützt wird durch einen Befestigungsisolator (14), der auf einer Innenseite der ersten inneren Seitenwand (11) befestigt ist.

2. Quelle nach Anspruch 1, bei der ein erster Glühfaden in der Nähe wenigstens eines zweiten Glühfadens ist.

3. Quelle nach einem der vorhergehenden Ansprüche, bei der die Zufuhr (19) ausgestaltet ist, um einen Strom geringer als 1 Ampere pro Zentimeter Länge des Glühfadens zu liefern.

4. Quelle nach einem der vorhergehenden Ansprüche, bei der die Glühfäden (13) parallel zu einer Achse der lonisationskammer und/oder einer Achse einer Beschleunigungskammer angeordnet sind.

5. Quelle nach einem der vorhergehenden Ansprüche, bei der der minimale Abstand zwischen zwei Glühfäden größer als 40, bevorzugt 50 Mal dem Durchmesser eines Glühfadens ist.

6. Quelle nach einem der vorhergehenden Ansprüche, bei der der minimale innere Umfang der lonisationskammer (3) größer ist als das Produkt einer Konstante, der Anzahl der Glühfäden (13) in der lonisationskammer (3), des Durchmessers eines Glühfadens (13) und eines Parameters, der die atomare Masse des Gases, das sich in der lonisationskammer (3) befindet, repräsentiert.

7. Verfahren nach Anspruch 6, bei dem der innere minimale Umfang der lonisationskammer (3) größer ist als 100 Mal das Produkt aus der Anzahl der Glühfäden (13) in der lonisationskammer (3), des Durchmessers eines Glühfadens (13), und der Quadratwurzel der atomaren Masse des Gases, das sich in der lonisationskammer (3) befindet.

8. Quelle nach einem der vorhergehenden Ansprüche, bei der die Glühfäden (13) ein Metall mit Schmelzpunkt oberhalb von 2 000 K aufweisen.

9. Quelle nach einem der vorhergehenden Ansprüche, bei der die Glühfäden (13) ein Durchmesser zwischen 0,1 und 0,5 mm, vorzugsweise zwischen 0,15 und 0,3 mm aufweisen.

10. Quelle nach einem der vorhergehenden Ansprüche, in der der Druck des zu ionisierenden Gases in der lonisationskammer (3) zwischen 0,5 und 1 Pa, vorzugsweise zwischen 1 Pa und 20 Pa aufweist.

11. Quelle nach einem der vorhergehenden Ansprüche, in der das zu ionisierende Gas Helium und 5 bis 25% Neon, vorzugsweise zwischen 5 und 15%, aufweist.
